# EUROPEAN PATENT APPLICATION

(11) **EP 3 480 894 A1**
(43) Date of publication of application: **08.05.2019**
(21) Application number: 17820274.3
(22) Date of filing: 29.06.2017
(51) Int. Cl.: H01Q 13/08, H01Q 21/06, H01Q 23/00

(54) **PLANE ANTENNA, CO-FIRED CERAMIC SUBSTRATE, AND QUASI-MILLIMETER-WAVE/MILLIMETER-WAVE WIRELESS COMMUNICATION MODULE**

(30) Priority: 30.06.2016 JP 2016130357
(71) Applicant: Hitachi Metals, Ltd., Tokyo 108-8224 (JP)
(72) Inventor: HAYASHI Kenji, Minato-ku, Tokyo 1088224 (JP); ENOKI Masato, Minato-ku, Tokyo 1088224 (JP)
(74) Representative: Fleuchaus, Michael A.
(86) International application number: PCT/JP2017/023943
(87) International publication number: WO 2018/003920

(57) **Abstract**

A planar antenna includes: a multilayer ceramic structure **10** having an upper surface and a lower surface and including a plurality of ceramic layers stacked with each other; at least one radiation conductor **31** located at one of interfaces between the ceramic layers **10;** and a ground conductor **32** located on the lower surface of the multilayer ceramic structure or at one of the interfaces between the ceramic layers that is on a lower surface side of the radiation conductor.

## Description

### TECHNICAL FIELD

The present application relates to a planar antenna, a co-fired ceramic substrate, and a quasi-millimeter wave/millimeter wave wireless communication module.

### BACKGROUND ART

There has been a dramatic increase in the amount of information transmitted over the Internet, and there has been a demand for a wireless communication technique with which it is possible to carry larger amounts of information. There has also been a demand for television broadcast with images of higher definitions.

With wireless communication, as the carrier frequency is higher, the frequency band used for transmitting information can be wider and more information can be carried. Therefore, in recent years, wireless communication has been widely used, e.g., wireless LAN in the microwave range, particularly from about 1 GHz to about 15 GHz, mobile phone network, satellite communication, etc.

A planar antenna is used, for example, as an antenna for use in such high-frequency wireless communication. Patent Document No. 1 discloses a planar antenna for a GPS receiving system, wherein an antenna conductor is provided on a printed wiring board. The antenna conductor is covered by a solder resist in order to prevent corrosion. Patent Document No. 2 discloses a planar antenna for a communication system for a microwave and millimeter wave region, wherein a conductor film and a protection film covering the conductor film are provided on a resin substrate.

### CITATION LIST

### PATENT LITERATURE

Patent Document No. 1: Japanese Laid-Open Patent Publication No. H6-140831
Patent Document No. 2: Japanese Laid-Open Patent Publication No. 2012-054826

### SUMMARY OF INVENTION

### TECHNICAL PROBLEM

In recent years, a wireless communication technique for a quasi-millimeter wave/millimeter wave band has been drawing attention as a short-range wireless communication technique for carrying larger amounts of information.

A non-limiting illustrative embodiment of the present application provides a planar antenna, a co-fired ceramic substrate, and a quasi-millimeter wave/millimeter wave wireless communication module, which are applicable to wireless communication of a quasi-millimeter wave/millimeter wave band.

### SOLUTION TO PROBLEM

A planar antenna according to one illustrative embodiment of the present disclosure includes: a multilayer ceramic structure having an upper surface and a lower surface and including a plurality of ceramic layers stacked with each other; at least one radiation conductor located at one of interfaces between the ceramic layers; and a ground conductor located on the lower surface of the multilayer ceramic structure or at one of the interfaces between the ceramic layers that is on a lower surface side of the radiation conductor.

Of the ceramic layers, the multilayer ceramic structure may include a first portion that is located between the upper surface and the at least one radiation conductor and a second portion that is located between the lower surface and the at least one radiation conductor.

A thickness of the first portion may be 70 µm or less.

A thickness of the first portion may be 5 µm or more and less than 20 µm.

The first portion of the multilayer ceramic structure may have a composition different from the second portion.

The first portion of the multilayer ceramic structure may have the same composition as the second portion.

The planar antenna may include a plurality of radiation conductors.

An interval between the radiation conductor and the ground conductor may be 50 µm or more and 1 mm or less.

The radiation conductor may be buried in the first portion and the second portion; and a height **He** of a portion of the radiation conductor that is buried in the first portion **10c** may be smaller than a height **Hd** of a portion of the radiation conductor that is buried in the second portion **10d**.

A co-fired ceramic substrate according to one illustrative embodiment of the present disclosure includes: a multilayer ceramic structure having an upper surface and a lower surface and including a plurality of ceramic layers stacked with each other; at least one radiation conductor located at one of interfaces between the ceramic layers; a ground conductor located on the lower surface of the multilayer ceramic structure or at one of the interfaces between the ceramic layers that is on a lower surface side of the radiation conductor; a plurality of conductor patterns located at one of the interfaces between the ceramic layers that is on a lower surface side of the radiation conductor; and a plurality of conductive vias provided in one of the ceramic layers that is located on a lower surface side of the radiation conductor, wherein: a planar antenna is formed by the radiation conductor, the ground conductor, and a portion of the ceramic layers located between the radiation conductor and the ground conductor; and the conductor patterns and the conductive vias form a passive element and a wire.

Of the ceramic layers, the multilayer ceramic structure may include a first portion that is located between the upper surface and the at least one radiation conductor and a second portion that is located between the lower surface and the at least one radiation conductor.

A thickness of the first portion may be 70 µm or less.

A thickness of the first portion may be 5 µm or more and less than 20 µm.

An interval between the radiation conductor and the ground conductor may be 50 µm or more and 1 mm or less.

The radiation conductor may be buried in the first portion and the second portion; and a height **Hc** of a portion of the radiation conductor that is buried in the first portion **10c** may be smaller than a height **Hd** of a portion of the radiation conductor that is buried in the second portion **10d**.

The first portion of the multilayer ceramic structure may have a composition different from the second portion.

The first portion of the multilayer ceramic structure may have the same composition as the second portion.

The co-fired ceramic substrate may include a plurality of radiation conductors.

The co-fired ceramic substrate may further include at least one of a conductive via and a conductive pattern that is formed in the multilayer ceramic structure and that directly electrically connects together the radiation conductor and the wire.

The co-fired ceramic substrate may further include at least one of a conductive via and a conductive pattern that is formed in the multilayer ceramic structure, that is electrically connected to the wire, and that can be electromagnetically coupled to the radiation conductor.

The co-fired ceramic substrate may further include a plurality of electrodes that are located on the lower surface and that are electrically connected to the wire.

A quasi-millimeter wave/millimeter wave wireless communication module according to one illustrative embodiment of the present disclosure includes: a co-fired ceramic substrate as set forth above; and an active element that is connected to the electrodes located on the lower surface of the multilayer ceramic structure.

### ADVANTAGEOUS EFFECTS OF INVENTION

According to an embodiment of the present disclosure, it is possible to realize a planar antenna, a co-fired ceramic substrate and a quasi-millimeter wave/millimeter wave wireless communication module, which are applicable to wireless communication of a quasi-millimeter wave/millimeter wave band.

### BRIEF DESCRIPTION OF DRAWINGS

FIGS. **1(a)**, **1(b)** and **1(c)** are a schematic top view, a schematic bottom view and a schematic cross-sectional view taken along line 1c-1c of FIG. **1(b)****,** showing an example embodiment of a co-fired ceramic substrate.
FIGS. **2(a)** and **2(b)** are plan views showing the shape of radiation conductors and a ground conductor on a co-fired ceramic substrate shown in FIG. **1****.**
FIG. **3(a)** is a schematic diagram showing an example of a positional relationship between a first portion and a second portion of the co-fired ceramic substrate and the radiation conductors, and FIGS. **3(b)** to **3(f)** are cross-sectional views showing steps for manufacturing the structure shown in FIG. **3(a)**.
FIG. **4(a)** is a schematic diagram showing another example of a positional relationship between a first portion and a second portion of the co-fired ceramic substrate and the radiation conductors, and FIGS. **4(b)** to **4(d)** are cross-sectional views showing steps for manufacturing the structure shown in FIG. **4(a)****.**
FIGS. **5(a)** and **5(b)** are partially exploded perspective views showing an example of a structure for supplying power to a radiation conductor.
FIG. **6(a)** is a schematic bottom view showing an example embodiment of a quasi-millimeter wave/millimeter wave wireless communication module, and FIG. **6(b)** is a schematic cross-sectional view showing a quasi-millimeter wave/millimeter wave wireless communication module mounted on a circuit substrate.
FIGS. **7(a)** and **7(b)** show the results of calculation for the relationship between the thickness of the first portion of the planar antenna structure shown in FIG. **1** and the radiation efficiency, and the relationship between the thickness of the first portion and the maximum gain.
FIG. **8** shows the results of calculation for the relationship between the dielectric loss of the first portion of the planar antenna structure shown in FIG. **1** and the radiation efficiency.
FIGS. **9(a)** and **9(b)** show the results of calculation for the relationship between the thickness of the first portion of the planar antenna structure shown in FIG. **1** and the radiation efficiency and the relationship between the thickness of the first portion and the maximum gain, where the dielectric constant is varied while tanδ of the first portion is set to 0.002.
FIGS. **10(a)** and **10(b)** show the results of calculation for the relationship between the thickness of the first portion of the planar antenna structure shown in FIG. **1** and the radiation efficiency and the relationship between the thickness of the first portion and the maximum gain, where the dielectric constant is varied while tanδ of the first portion is set to 0.005.
FIGS. **11(a)** and **11(b)** show the relationship between the thickness **d1** and the radiation efficiency and the relationship between the thickness **d1** and the maximum gain, respectively, where the dielectric constant of the ceramic layer is 6 and tanδ is set to 0.002, 0.003 and 0.005.
FIGS. **12(a)** and **12(b)** show the relationship between the thickness **d2** and the radiation efficiency and the relationship between the thickness **d2** and the maximum gain, where the thickness **d1** of the first portion **10c** is 20 µm.

### DESCRIPTION OF EMBODIMENTS

The planar antenna of the present disclosure is applicable to wireless communication of a quasi-millimeter wave/millimeter wave band, for example. With wireless communication of a millimeter wave band, a radio wave whose wavelength is 1 mm to 10 mm and whose frequency is 30 GHz to 300 GHz is used as the carrier wave. With wireless communication of a quasi-millimeter wave band, a radio wave whose wavelength is 10 mm to 30 mm and whose frequency is 10 GHz to 30 GHz is used as the carrier wave. With wireless communication of a quasi-millimeter wave/millimeter wave band, the size of the planar antenna is several centimeters or on the order of millimeters. Therefore, when a quasi-millimeter wave/millimeter wave wireless communication circuit is formed by using a multilayer ceramic sintered substrate (e.g., a co-fired ceramic substrate **101),** for example, the planar antenna of the present disclosure can be mounted on a multilayer ceramic sintered substrate.

On the other hand, a wireless communication circuit of a quasi-millimeter wave/millimeter wave band has a large influence of transmission loss. Therefore, it has been believed that a conduction loss occurs and it is not possible to transmit a radio wave with a high efficiency when the surface of a planar antenna for transmitting and receiving radio waves is covered by a protection film, or the like, as disclosed in Patent Document Nos. 1 and 2. However, a study by the present inventors revealed that it is possible to suppress the decrease in radiation efficiency when the planar antenna is covered by a ceramic, e.g., a ceramic of a multilayer ceramic substrate, rather than a resin as disclosed in Patent Document No. 1. Embodiments of a planar antenna, a co-fired ceramic substrate and a quasi-millimeter wave/millimeter wave wireless communication module of the present disclosure will now be described in detail.

### (First Embodiment)

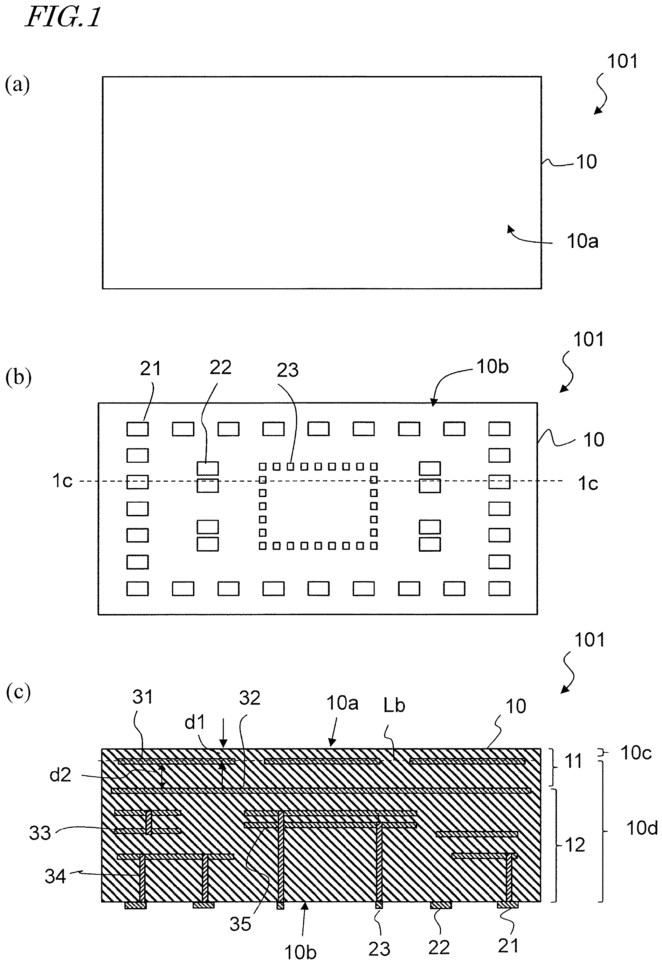

An embodiment of a planar antenna and a co-fired ceramic substrate will be described. FIGS. **1(a)** and **1(b)** are a schematic top view and a bottom view, respectively, of the co-fired ceramic substrate **101** according to an embodiment of the present disclosure. FIG. **1(c)** is a cross section of the co-fired ceramic substrate **101** taken along line 1c-1c shown in FIG. **1(b)**.

The co-fired ceramic substrate **101** includes a multilayer ceramic structure **10,** at least one radiation conductor **31,** and a ground conductor **32.**

The multilayer ceramic structure **10** includes an upper surface **10a** and a lower surface **10b.** The multilayer ceramic structure **10** includes a plurality of ceramic layers obtained by laminating and co-firing green sheets. In the multilayer ceramic structure **10,** clear boundaries may be absent in some cases between the ceramic layers. Each ceramic layer corresponds to one green sheet.

The radiation conductors **31** are located at one of the interfaces between ceramic layers. The ground conductor **32** is located on the lower surface **10b** or on another one of the interfaces between ceramic layers that is on the lower surface **10b** side of the radiation conductor **31.** In FIG. **1****,** the ground conductor **32** is located on the lower surface **10b** side of the radiation conductor **31** in the multilayer ceramic structure **10.**

The ceramic layers of the multilayer ceramic structure **10** include a first portion **10c** that is located between the upper surface **10a** and the radiation conductor **31,** and a second portion **10d** that is located between the lower surface **10b** and the radiation conductors **31.** As shown in FIG. **1(c)****,** a plurality of ceramic layers located from the upper surface **10a** to the ground conductor **32,** the radiation conductors **31** and the ground conductor **32** together form a planar antenna **11.** The planar antenna **11** is a patch antenna in the present embodiment, and is a microstrip antenna formed by the radiation conductors **31,** the ground conductor **32** and one or more ceramic layers that are sandwiched between the radiation conductors **31** and the ground conductor **32.**

In the multilayer ceramic structure **10,** the interface **Lb** between the first portion **10c** and the second portion **10d** is identified as the position of the visible interface if such an interface of the ceramic layer is visible when the cross section of the co-fired ceramic substrate **101** is observed by an optical microscope, or the like. When a clear interface is not visible, the height defined as the interval between the upper surface **10a** and the lower surface **10b** is divided by the number of layers of ceramic green sheets stacked when producing the multilayer ceramic structure **10** so as to obtain the thickness per one ceramic layer, and the obtained thickness is multiplied by the number of ceramic green sheets that are formed on the radiation conductors **31.** Thus, it is possible to obtain the thickness of the first portion **10c,** i.e., the position of the interface **Lb** between the first portion **10c** and the second portion **10d**.

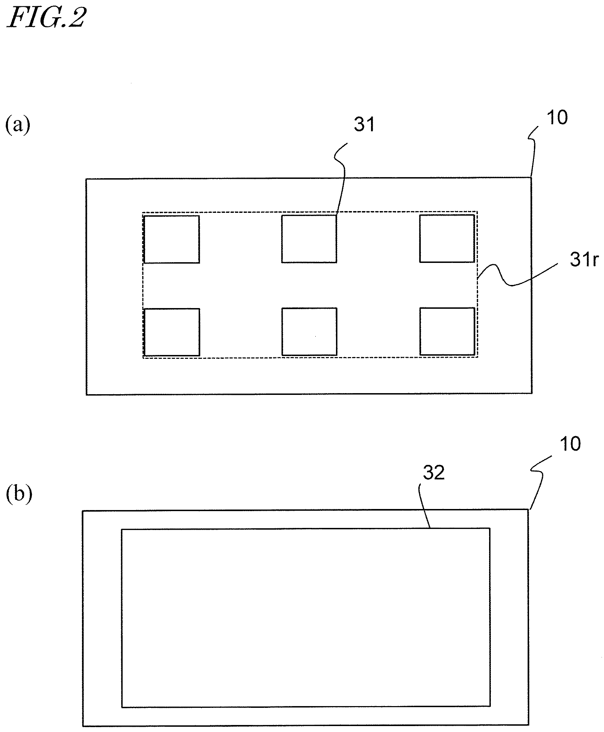

FIG. **2(a)** is a plan view showing the shape and the arrangement of the radiation conductors **31.** The radiation conductors **31** are radiating elements for radiating radio waves, and are formed from a conductive layer. In the present embodiment, each radiation conductor **31** has a rectangular (square) shape. For example, when the shape of the radiation conductors **31** is rectangular, the length of one side of the radiation conductor **31** is 1/2 the wavelength of the carrier wave, more specifically, 5 mm or less. However, the radiation conductors **31** may have a circular shape or any other shape.

In the present embodiment, the planar antenna **11** includes six radiation conductors **31,** which are arranged two-dimensionally on the same one of the interfaces between the ceramic layers. That is, the radiation conductors **31** together form an array antenna. Since this configuration increases the number of antennas, it is possible to increase the maximum gain. It also makes it possible to adjust the directionality of a radio wave to be radiated or received, thereby realizing a wide or narrow directionality. Even when some of the plurality of planar antennas break, the function as an antenna can be maintained, and it is possible to increase the reliability of the antenna.

FIG. **2(b)** is a plan view showing the shape of the ground conductor **32.** The ground conductor **32** is also formed from a conductive layer. It is preferred that the ground conductor **32** is sized so as to completely include a region **31r** of the array of the radiation conductors **31** and is arranged with respect to the radiation conductors **31** so as to completely include the region **31r,** as seen from the direction of lamination of the multilayer ceramic structure **10**, as shown in FIGS. **2(a)** and **2(b)****.**

The first portion **10c** of the multilayer ceramic structure **10** completely covers the entirety of the radiation conductor **31** so that the radiation conductor 31 is not exposed to the ambient environment. Thus, it is possible to prevent the radiation conductor **31** from being exposed to the ambient environment to be corroded and oxidized, thereby suppressing the decrease in radiation efficiency and the change in antenna characteristics. Moreover, when manufacturing a quasi-millimeter wave/millimeter wave wireless communication module using the co-fired ceramic substrate **101,** it is possible to prevent some external force from being applied to the radiation conductors **31,** thereby suppressing the deformation, etc. Particularly, an antenna of a quasi-millimeter wave/millimeter wave band has a small size and the characteristics thereof may vary significantly even for a small change in shape, and it is therefore important to protect the radiation conductors **31.**

The surface roughness Ra of the upper surface **10a,** which is also the surface of the first portion **10c,** is 0.5 µm or less, for example. The surface roughness Ra of the upper surface **10a** is preferably 0.1 µm or more and 0.3 µm or less, and more preferably 0.15 µm or more and 0.2 µm or less. When the surface roughness Ra is in this range, the thickness of the layer of the first portion **10c** can be made uniform, and it is possible to make a film that is unlikely to deteriorate.

With the surface roughness Ra of the film exceeding 0.5 µm, when the surface is exposed to a chemical solution for plating terminals, etc., the film may be likely to be deteriorated or etched. In view of the corrosion resistance and the weather resistance, the surface roughness Ra is preferably 0.5 µm or less. When the surface roughness Ra of the film is smaller than 0.15 µm, the process difficulty increases, and the number of steps may increase to deteriorate the manufacturing efficiency. Therefore, the surface roughness Ra is preferably 0.15 µm or more. Note that the surface roughness Ra is an arithmetic mean roughness.

The first portion **10c,** which functions as the protection layer for the radiation conductors **31,** is preferably closely packed. Therefore, the porosity of the first portion **10c** is preferably smaller than the porosity of the second portion **10d**. For example, the porosity of the first portion **10c** is preferably 2% or less, more preferably 1.5% or less, and even more preferably 1.0% or less. Since when the porosity is high, the surface roughness Ra tends to also increase, it is desirable to decrease the porosity in order to suppress Ra. Note that the porosity (%) is obtained by observing the layer cross section and using the formula (total area of pores) / (area observed) × 100.

As will be described below in detail, the thickness **d1** of the first portion **10c** is preferably 70 µm or less. Then, it is possible to realize a radiation efficiency that is equal to or greater than that of an Au/Ni-plated antenna, which is commonly used as a planar antenna. Since the radiation conductor **31** is buried in the first portion **10c** and the second portion **10d** as described above, the thickness **d1** of the first portion **10c** varies between a portion where the radiation conductor **31** is located and other portions. In the present disclosure, the thickness **d1** of the first portion **10c** refers to the thickness in the region where the radiation conductor **31** is located.

Note that the radiation efficiency is dependent on the dielectric constant of the first portion **10c** of the multilayer ceramic structure **10.** As will be described below, the dielectric constant of the ceramic layer is preferably small, for example, in order to co-fire the co-fired ceramic substrate **101** at a low temperature. Even if a low dielectric constant ceramic whose dielectric constant is about 5 to 10 is used, the thickness **d1** of the first portion **10c** is more preferably less than 20 µm in order to realize a radiation efficiency that is equal to or greater than an Au/Ni-plated planar antenna.

The loss is less as the thickness **d1** of the first portion **10c** is smaller, and there is no particular limitation on the lower limit of the thickness **d1** in view of the antenna characteristics. However, if the thickness **d1** of the first portion **10c** is too small, it may be difficult to realize a uniform thickness. In order to form the first portion **10c** of a uniform thickness, the thickness **d1** of the first portion **10c** is preferably 5 µm, for example. That is, the thickness **d1** of the first portion is preferably 5 µm or more and 70 µm or less, and more preferably 5 µm or more and less than 20 µm. The first portion **10c** may be a ceramic layer or may be formed from two or more ceramic layers.

If the first portion **10c** of the multilayer ceramic structure **10** is thin (the thickness thereof is small), when a green sheet stack including a conductive pattern to be the radiation conductors **31** are pressure-bonded together when manufacturing the co-fired ceramic substrate **101,** the stress due to the thickness of the conductive pattern of the radiation conductors **31** is localized at the ceramic green sheet to be the first portion **10c** on the upper surface **10a** side. Therefore, the ceramic green sheet to be the first portion **10c** and/or the sintered first portion **10c** are likely to crack.

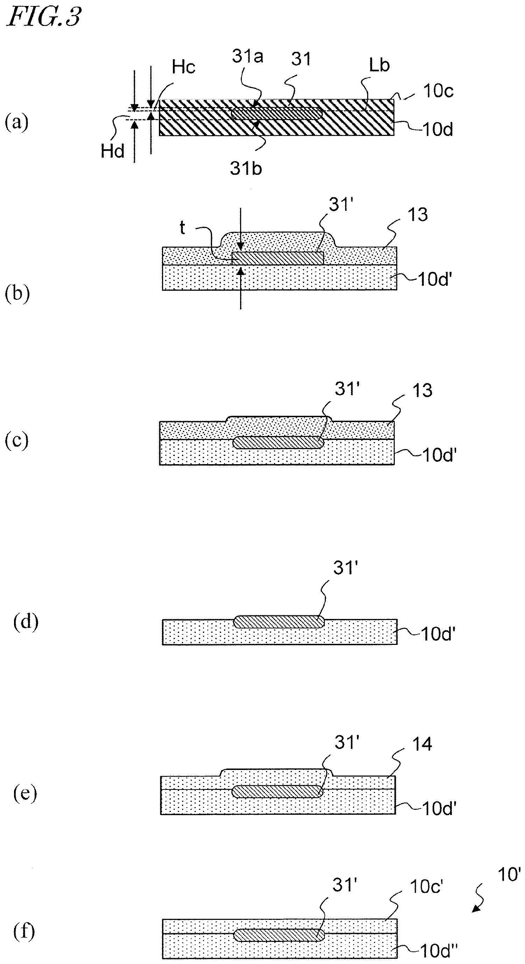

Therefore, as shown in FIG. **3(a)****,** the height **Hc** of a portion of the radiation conductor **31** of the multilayer ceramic structure **10** that is buried in the first portion **10c** is preferably smaller than the height **Hd** of a portion that is buried in the second portion **10d**. The heights **Hc** and **Hd** are each defined as the distance from the position **Lb** of the interface between the first portion **10c** and the second portion **10d** based on the definition described above to an upper surface **31a** or a lower surface **31b** of the radiation conductor **31.**

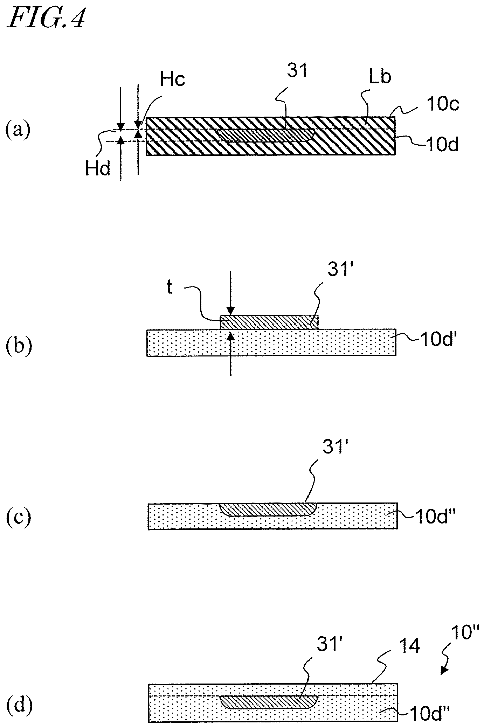

Alternatively, it is preferred that generally the entirety of the radiation conductor **31** in the multilayer ceramic structure **10** is preferably buried in the second portion **10d**, as shown in FIG. **4(a)****.** That is, it is preferred that the height **Hc** of a portion that is buried in the first portion **10c** is substantially zero, and that the height **Hd** of a portion that is buried in the second portion **10d** is substantially equal to the height of the radiation conductor **31.** As will be described below, with this structure, it is possible to reduce the stress to be applied to the ceramic green sheet to be the first portion **10c** when manufacturing the co-fired ceramic substrate **101,** and it is therefore possible to suppress the occurrence of a crack described above.

The thickness **d2** of the ceramic layer between the radiation conductor **31** and the ground conductor **32,** which is the interval between the radiation conductor **31** and the ground conductor **32,** is 50 µm or more and 1 mm or less, for example. Then, it is possible to configure a microstrip antenna of a quasi-millimeter wave/millimeter wave band. The thickness **d2** is preferably 70 µm or more and 180 µm or less, and more preferably 100 µm or more and 150 µm or less. With the thickness **d2** being a value in this range, the planar antenna **11** can realize a high radiation efficiency and a high maximum gain.

The co-fired ceramic substrate **101** may further include a passive element pattern **33** and a wiring pattern **35,** which are located at the boundary between a plurality of ceramic layers located on the lower surface **10b** side of the ground conductor **32,** and a conductive via **34** provided in a plurality of ceramic layers located on the lower surface **10b** side of the ground conductor **32.** The passive element pattern **33** is a conductive layer or a ceramic having a predetermined resistance value, for example, and forms an inductor, a condenser, a resistor, etc. The conductive via **34** and the wiring pattern **35** are connected to the passive element pattern **33,** the ground conductor **32,** etc., to form a predetermined circuit.

As shown in FIG. **1(b)**, an electrode **21** for connection with an external substrate, an electrode **22** for connection with a passive element and an electrode **23** for connection with a passive element such as an integrated circuit are located on the lower surface **10b** of the multilayer ceramic structure **10.** The conductive via **34** electrically connects the electrodes **21, 22** and **23** with the wiring pattern **35,** etc.

These components provided on ceramic layers that are located on the lower surface **10b** side of the ground conductor **32** together form a wiring circuit **12** including passive elements. A wireless communication circuit is formed by connecting a passive element, an integrated circuit, etc., to the electrode **22** and the electrode **23** of the wiring circuit **12.**

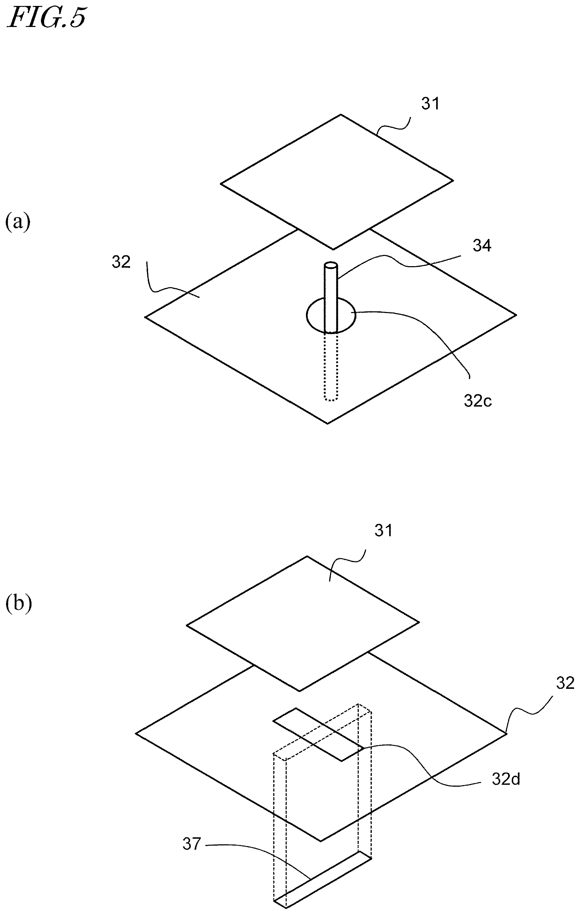

The wiring circuit **12** and the radiation conductor **31** of the planar antenna **11** may be electrically connected directly to each other via at least one of the conductive via **34** and the wiring pattern **35** formed in the multilayer ceramic structure **10.** FIG. **5(a)** schematically shows a configuration where the radiation conductor **31** and the wiring circuit **12** are connected together via the conductive via **34.** A through hole **32c** is provided in the ground conductor **32,** and the conductive via **34** is arranged in the through hole **32c.** One end of the conductive via **34** is connected to the radiation conductor **31,** and the other end is connected to the wiring circuit **12** (not shown).

Alternatively, at least one of the conductive via **34** and the wiring pattern **35** may be arranged at a position where it can be electromagnetically coupled to the radiation conductor **31.** In this case, for example, as shown in FIG. **5(b)****,** a slot **32d** may be provided in the ground conductor **32,** and the radiation conductor **31** and a strip conductor **37** may be arranged via the slot **32d.** The strip conductor **37** is connected to the wiring circuit **12** (not shown). Alternatively, the strip conductor **37** may be provided between the radiation conductor **31** and the ground conductor **32.**

The co-fired ceramic substrate **101** may be a low temperature co-fired ceramic (LTCC) substrate or a high temperature co-fired ceramic (HTCC) substrate. In view of the high frequency characteristics, there may be cases where it is preferred to use a low temperature co-fired ceramic substrate. A ceramic material and a conductive material selected in accordance with the sintering temperature, the application, etc., the frequency of wireless communication, etc., are used for the ceramic layer, the radiation conductor **31,** the ground conductor **32,** the passive element pattern **33,** the wiring pattern **35** and the conductive via **34** of the multilayer ceramic structure **10.** A conductive paste for forming the radiation conductor **31,** the ground conductor **32,** the passive element pattern **33,** the wiring pattern **35** and the conductive via **34** and a green sheet for forming a ceramic layer of the multilayer ceramic structure **10** are co-fired. When the co-fired ceramic substrate **101** is a low temperature co-fired ceramic substrate, a ceramic material and a conductive material that can be sintered in a temperature range of about 800°C to about 1000°C are used. For example, the ceramic material used may be a ceramic material including Al, Si and Sr as its main components and Ti, Bi, Cu, Mn, Na and K as its sub-components, a ceramic material including Al, Si and Sr as its main components and Ca, Pb, Na and K as its sub-components, a ceramic material including Al, Mg, Si and Gd, and a ceramic material including Al, Si, Zr and Mg. The conductive material used may be a conductive material including Ag or Cu. The dielectric constant of the ceramic material is about 3 to about 15. When the co-fired ceramic substrate **101** is a high temperature co-fired multi-layer ceramic substrate, a ceramic material including Al as its main components, and a conductive material including W (tungsten) or Mo (molybdenum) may be used.

More specifically, the LTCC material may be for example any of various materials including a low dielectric constant (dielectric constant: 5 to 10) Al-Mg-Si-Gd-O-based dielectric material, a dielectric material made of a crystal phase made of Mg₂SiO₄ and an Si-Ba-La-B-O-based glass, or the like, an Al-Si-Sr-O-based dielectric material, an Al-Si-Ba-O-based dielectric material, a high dielectric constant (dielectric constant: 50 or more) Bi-Ca-Nb-O-based dielectric material, etc.

For example, if an Al-Si-Sr-O-based dielectric material includes an oxide of Al, Si, Sr or Ti as its main component, it is preferred that it includes Al₂O₃: 10 to 60% by mass, SiO₂: 25 to 60% by mass, SrO: 7.5 to 50% by mass or TiO₂: 20% by mass or less (including 0), where the main components, Al, Si, Sr and Ti, are converted to Al₂O₃, SiO₂, SrO and TiO₂, respectively. With respect to 100 parts by mass of the main component, it is preferred to include, as its sub-component, at least one of the group of Bi, Na, K and Co by an amount of 0.1 to 10 parts by mass in terms of Bi₂O₃, 0.1 to 5 parts by mass in terms of Na₂O, 0.1 to 5 parts by mass in terms of K₂O, or 0.1 to 5 parts by mass in terms of CoO, and further include at least one of the group of Cu, Mn and Ag by an amount of 0.01 to 5 parts by mass in terms of CuO, 0.01 to 5 parts by mass in terms of Mn₃O₄, or 0.01 to 5 parts by mass of Ag. In addition, unavoidable impurities may be included.

The first portion **10c** of the multilayer ceramic structure **10** may have the same composition and be formed from the same material as the second portion **10d**. Alternatively, in order to increase the radiation efficiency of the planar antenna **11,** the first portion **10c** of the multilayer ceramic structure **10** may have a different composition and be formed from a different material from the second portion **10d**. As the first portion **10c** has a composition different from the second portion **10d**, it can have a different dielectric constant from the second portion **10d**, and it is possible to improve the radiation efficiency.

In order for the porosity of the first portion **10c** to be smaller than the second portion **10d** porosity, the amount to be added of an organic component such as a binder or a plasticizer in the ceramic green sheet to be the first portion **10c** is made smaller than the ceramic green sheet to be the second portion **10d**.

The co-fired ceramic substrate **101** may be manufactured by using a similar manufacturing method as an LTCC substrate or an HTCC substrate.

For example, first, a ceramic material including elements as described above is prepared and subjected to preliminary sintering at 700°C to 850°C, for example, as necessary, and pulverized into grains. A glass component powder, an organic binder, a plasticizer and a solvent are added to the ceramic material, thereby obtaining a slurry of the mixture. When different materials are used to form the first portion **10c** and the second portion **10d** of the multilayer ceramic structure **10** in order to realize different dielectric constants, for example, two different slurries including different materials are prepared. A powder of the conductive material described above is mixed with an organic binder and a solvent, etc., thereby obtaining a conductive paste.

A layer of the slurry having a predetermined thickness is formed on a carrier film by using a doctor blade method, a rolling (extrusion) method, a printing method, an inkjet application method, a transfer method, or the like, and the layer is dried. The slurry layer is severed to obtain ceramic green sheets.

Next, in accordance with a circuit to be formed in the co-fired ceramic substrate **101**, via holes are formed in the plurality of ceramic green sheets by using a laser, a mechanical puncher, or the like, and the via holes are filled with a conductive paste by using a screen printing method. A conductive paste is printed on the ceramic green sheets by using a screen printing, or the like, to form a wiring pattern, a passive element pattern, a radiation conductor pattern and a ground conductor pattern on the ceramic green sheet.

The ceramic green sheets with the conductive paste described above arranged thereon are sequentially stacked with each other with preliminary pressure-bonding therebetween, thereby forming a green sheet stack. Then, the binder is removed from the green sheet stack, and the debindered green sheet stack is co-fired. Thus, the co-fired ceramic substrate **101** is completed.

As described above with reference to FIG. **3(a)** and FIG. **4(a)****,** when producing the co-fired ceramic substrate **101** having a structure in which the radiation conductor **31** is buried deeper in the second portion **10d**, the ceramic green sheets are stacked with each other with preliminary pressure-bonding therebetween to produce a part of the multilayer ceramic structure **10** corresponding to the second portion **10d**.

Then, when producing a structure shown in FIG. **3(a)**, a conductive paste pattern **31'** to be the radiation conductor **31** having the thickness **t** is formed on a green sheet stack **10d'** corresponding to the second portion **10d** as shown in FIG. **3(b)****.** A sheet **13** made of a resin such as PET, for example, is arranged thereon so as to cover the pattern **31'.** As shown in FIG. **3(c)****,** the pattern **31'** is pressed against the green sheet stack **10d'** by using a die, or the like, over the sheet **13.** Since the hardness of the sheet **13** is higher than the ceramic green sheet of the green sheet stack **10d',** the surface of the green sheet stack **10d'** is more easily deformed than the sheet **13.** As a result, the pattern **31'** is buried to a depth of t/2 or more in the green sheet stack **10d'.** Then, the sheet **13** is removed as shown in FIG. **3(d)****,** and a ceramic green sheet **14** is arranged on the green sheet stack **10d'** covering the pattern **31'** as shown in FIG. **3(e)**. The ceramic green sheet **14** is pressed against the green sheet stack **10d'** using a die, or the like, for pressure-bonding, thereby obtaining a green sheet stack **10'** as shown in FIG. **3(f)****.** In the green sheet stack **10',** the pattern **31'** is buried to a depth of t/2 ore more in a portion **10d"** corresponding to the second portion **10d**, and to a depth of t/2 or less in a portion **10c'** corresponding to the first portion **10c.**

Then, the binder is removed from the green sheet stack **10',** and the debindered green sheet stack is co-fired. Thus, the co-fired ceramic substrate **101** is completed.

When producing a structure shown in FIG. **4(a)****,** a conductive paste pattern **31'** to be the radiation conductor **31** having the thickness **t** is formed on a green sheet stack **10d'** corresponding to the second portion **10d** as shown in FIG. **4(b)**. The pattern **31'** is pressed against the green sheet stack **10d'** by using a die, or the like, and substantially the entirety of the pattern **31'** is buried from the surface into the inside of the green sheet stack **10d'** as shown in FIG. **4(c)**.

The ceramic green sheet **14** is arranged on the green sheet stack **10d"** so as to cover the pattern **31"**. The ceramic green sheet **14** is pressed against the green sheet stack **10d"** by using a die, or the like, for pressure-bonding. Thus, a green sheet stack **10"** is obtained as shown in FIG. **4(d)**. In the green sheet stack **10"**, substantially the entirety of the pattern **31'** is buried in the portion **10d"** corresponding to the second portion **10d**.

Then, the binder is removed from the green sheet stack **10',** and the debindered green sheet stack is co-fired. Thus, the co-fired ceramic substrate **101** is completed.

The co-fired ceramic substrate of the present embodiment includes a wiring circuit, a passive element and a planar antenna for quasi-millimeter wave/millimeter wave wireless communication. Therefore, by mounting a chip set, or the like, for quasi-millimeter wave/millimeter wave wireless communication on the co-fired ceramic substrate, it is possible to realize a wireless module that includes an antenna.

Since the first portion **10c** of the multilayer ceramic structure **10** completely covers the entirety of the radiation conductor **31,** it is possible to protect the radiation conductor **31** from the ambient environment and external forces, and it is possible to suppress the decrease in radiation efficiency and the change in antenna characteristics.

Note that the shape, the number and the arrangement of the radiation conductors **31** and the ground conductor **32** of the planar antenna described in the present embodiment are merely schematic examples. For example, some of the radiation conductors may be arranged at the interface of the ceramic layer that is located at a different distance **(d2)** from the ground conductor **32.** The radiation conductors may be provided with slots. The planar antenna may further include conductors to which no electricity is supplied, in addition to the radiation conductors, and the conductors may be layered with the radiation conductors with a ceramic layer interposed therebetween.

### (Second Embodiment)

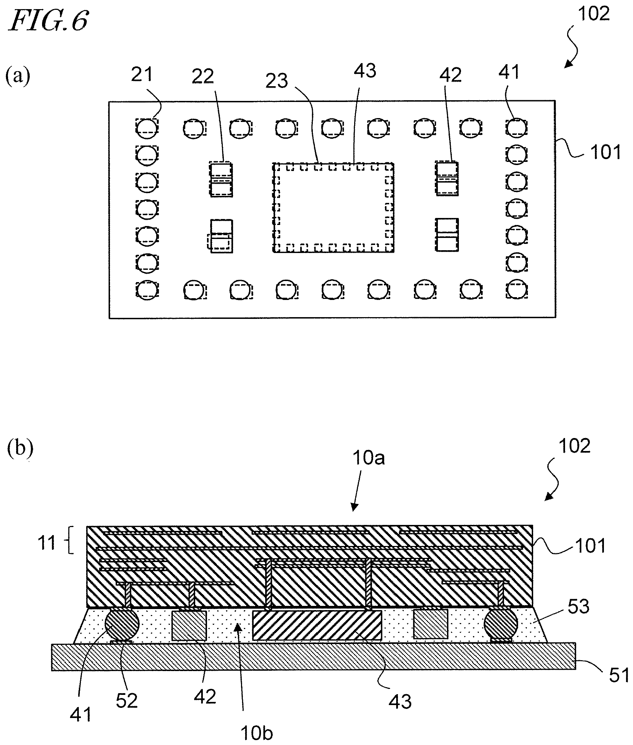

An embodiment of a quasi-millimeter wave/millimeter wave wireless communication module will be described. FIG. **6(a)** is a schematic bottom view showing an embodiment of a wireless communication module of the present disclosure, and FIG. **6(b)** is a schematic cross-sectional view showing a wireless communication module mounted on a substrate. A wireless communication module **102** includes the co-fired ceramic substrate **101** of the first embodiment, a solder bump **41,** a passive element **42,** and an active element **43.** The solder bump **41** is provided at the electrode **21** located on the lower surface **10b** of the co-fired ceramic substrate **101.** The passive element **42** is a chip condenser, a chip inductor, a chip resistor, or the like, for example, and is attached to the electrode **22** via a solder, or the like. The active element **43** is a chip set for wireless communication, for example, and includes a receiving circuit, a transmitting circuit, an A/D converter, a D/A converter, a baseband processor, a medium access controller, etc.

The wireless communication module **102** is attached to a circuit substrate **51** with an electrode **52** provided thereon, for example, by flip-chip bonding, facing down, i.e., so that the passive element **42** and the active element **43** oppose the circuit substrate **51.** The gap between the co-fired ceramic substrate **101** and the circuit substrate **51** is filled with a seal resin **53,** for example.

In the wireless communication module **102** mounted on the circuit substrate **51,** the upper surface **10a** of the co-fired ceramic substrate **101** is located on the opposite side from the circuit substrate **51.** Therefore, it is possible to radiate a radio wave of a quasi-millimeter wave/millimeter wave band from the planar antenna **11** and to receive a radio wave of a quasi-millimeter wave/millimeter wave band coming from outside by the planar antenna **11,** without being influenced by the passive element **42** and the active element **43** or the circuit substrate **51.** Thus, it is possible to realize a small-sized wireless communication module including an antenna that can be surface mounted.

### (Experiment Example 1)

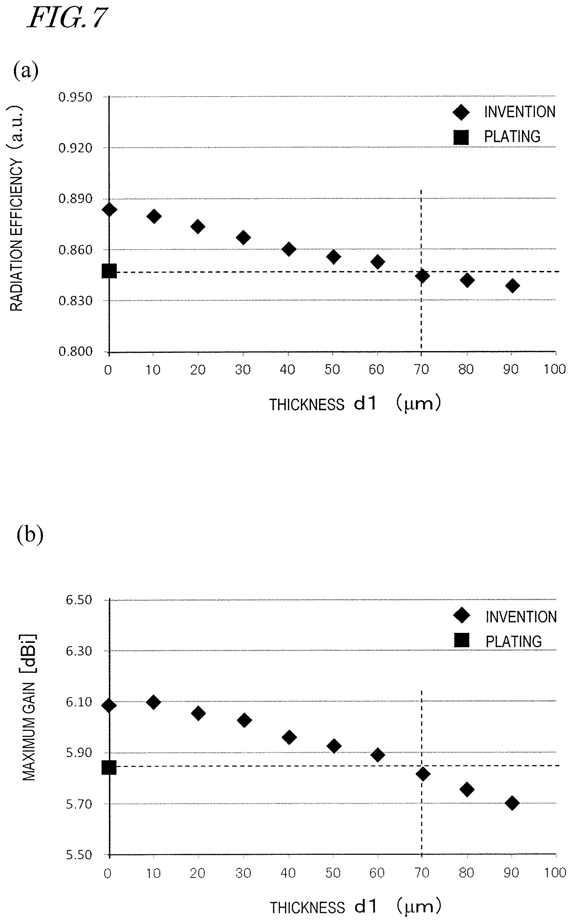

In order to examine the radiation efficiency when a ceramic layer is provided on the surface of the radiation conductor, the radiation efficiency was calculated, while varying the thickness **d1** of the first portion **10c,** by using a structure that corresponds to the planar antenna **11** (FIG. **1****)** of the first embodiment. The radiation conductor **31** was designed so that a radio wave of 60 GHz can be transmitted. The dielectric constant of the ceramic layer was set to 4. FIG. **7(a)** shows the relationship between the thickness **d1** of the first portion **10c** and the radiation efficiency. FIG. **7(b)** shows the relationship between the thickness **d1** of the first portion **10c** and the maximum gain. For the purpose of comparison, the radiation conductor was plated, and the radiation efficiency of the planar antenna whose surface was exposed was measured to be about 0.85. The plating had a 3-layer structure of Au:0.1 µm / Pd:0.15 µm / Ni:12 µm, and an Ag layer having a thickness of 12 µm was used for the radiation conductor.

As shown in FIG. **7****,** the radiation efficiency (and the maximum gain) decreases as the thickness of the first portion **10c,** which is a ceramic layer covering the radiation conductor, increases. It can be seen that in order to realize a radiation efficiency that is similar to or greater than that of the reference example, the thickness **d1** of the first portion **10c** is preferably 70 µm or less. Particularly, it can be seen that a higher radiation efficiency (and maximum gain) can be realized if the thickness **d1** is less than 20 µm.

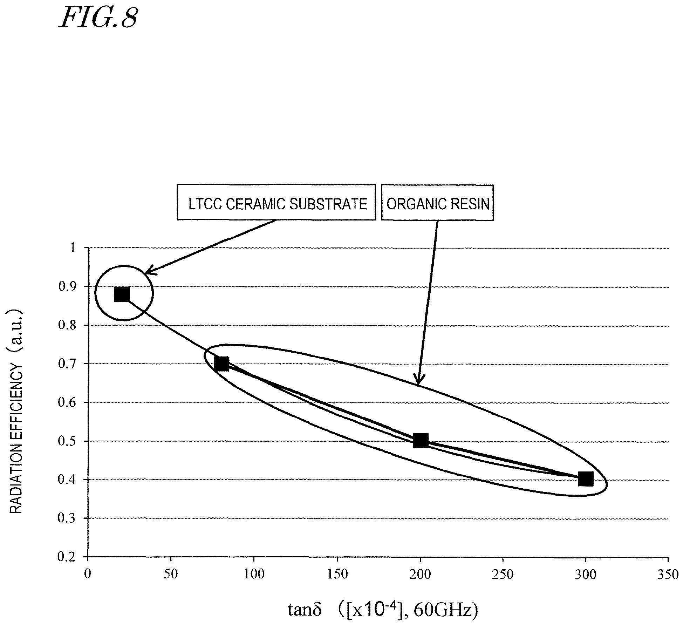

FIG. **8** shows the results of calculation for the radiation efficiency of a structure that corresponds to the planar antenna **11** of the first embodiment (FIG. **1****)** when varying the dielectric loss tanδ of the material of the first portion **10c.** As shown in FIG. **8****,** as the dielectric loss is smaller, the radiation efficiency of the antenna is higher. As shown in FIG. **8****,** an organic resin has a relatively large dielectric loss, and the dielectric loss tanδ is 50×10⁻⁴ or more, for example. When such a material having a relatively large dielectric loss is provided on the surface of the radiation conductor, the radiation efficiency is likely to decrease substantially. It was found that in contrast, a ceramic used for an LTCC substrate has a small dielectric loss, and it is possible to realize a high radiation efficiency.

### (Experiment Example 2)

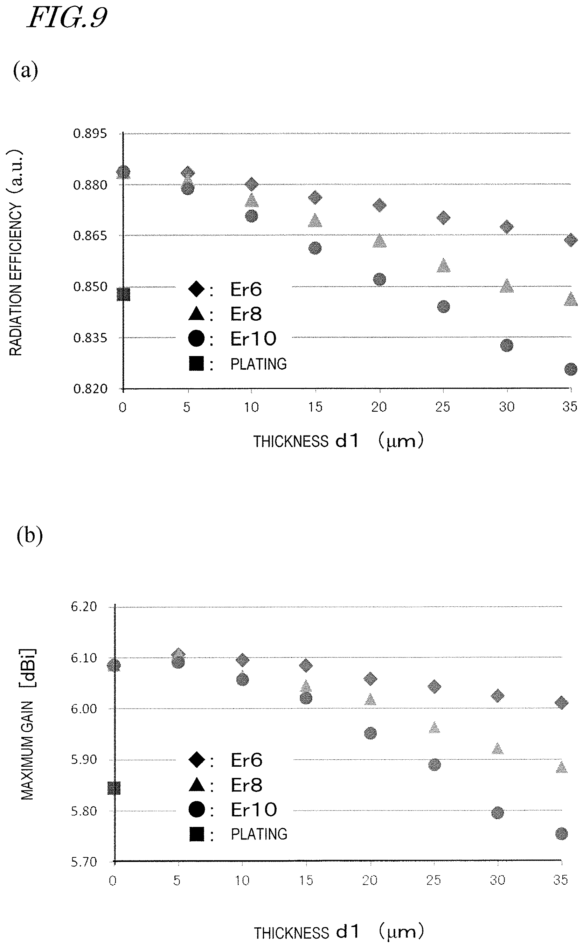

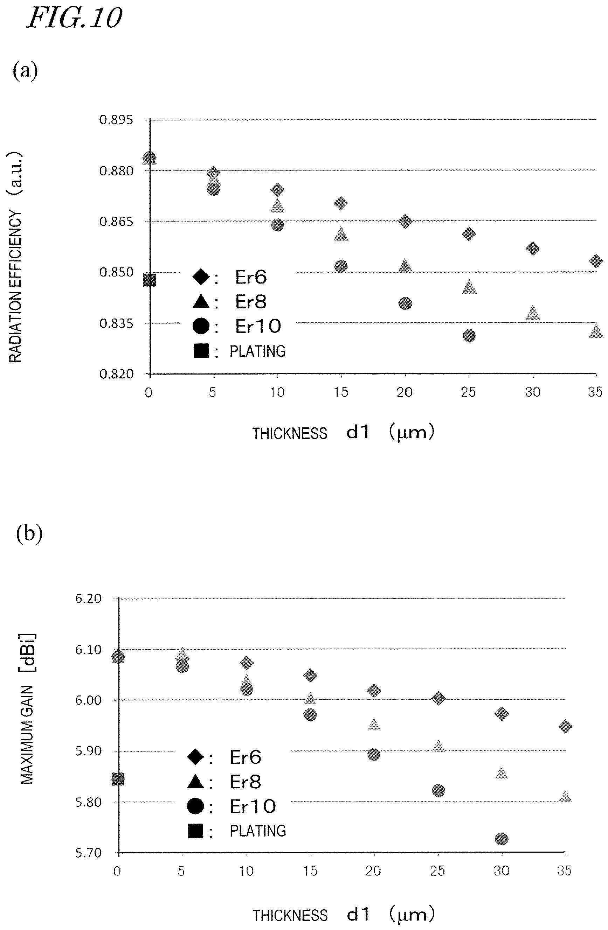

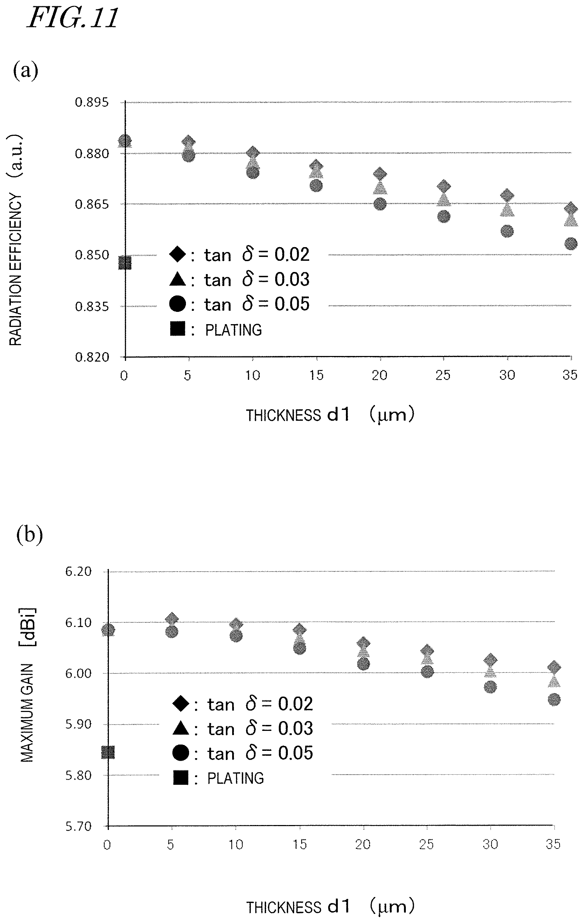

In order to examine the relationship between the dielectric constant of the first portion **10c** and the characteristics of the planar antenna **11,** the radiation efficiency and the maximum gain were calculated as in Experiment Example 1 while varying the dielectric constant of the ceramic layer. FIGS. **9(a)** and **9(b)** respectively show the relationship with the radiation efficiency when tanδ of the ceramic layer is 0.002, and the relationship between the maximum gain and the thickness **d1**, and FIGS. **10(a)** and **10(b)** respectively show the relationship with the radiation efficiency when tanδ of the ceramic layer is 0.005, and the relationship between the maximum gain and the thickness **d1**. These figures show calculation results for dielectric constants of 6, 8 and 10. FIGS. **11(a)** and **11(b)** respectively show the relationship between the thickness **d1** and the radiation efficiency and the relationship between the thickness **d1** and the maximum gain when the dielectric constant of the ceramic layer is 6 and tanδ is set to 0.002, 0.003 and 0.005.

Based on these results, the radiation efficiency and the maximum gain tend to decrease as the dielectric constant of the first portion **10c** increases. However, it can be seen that when the thickness **d1** is less than 20 µm, it is possible to realize a radiation efficiency and a maximum gain that are equal to or greater than those of an Au/Ni-plated planar antenna even if the dielectric constant of the first portion **10c** is about 10.

### (Experiment Example 3)

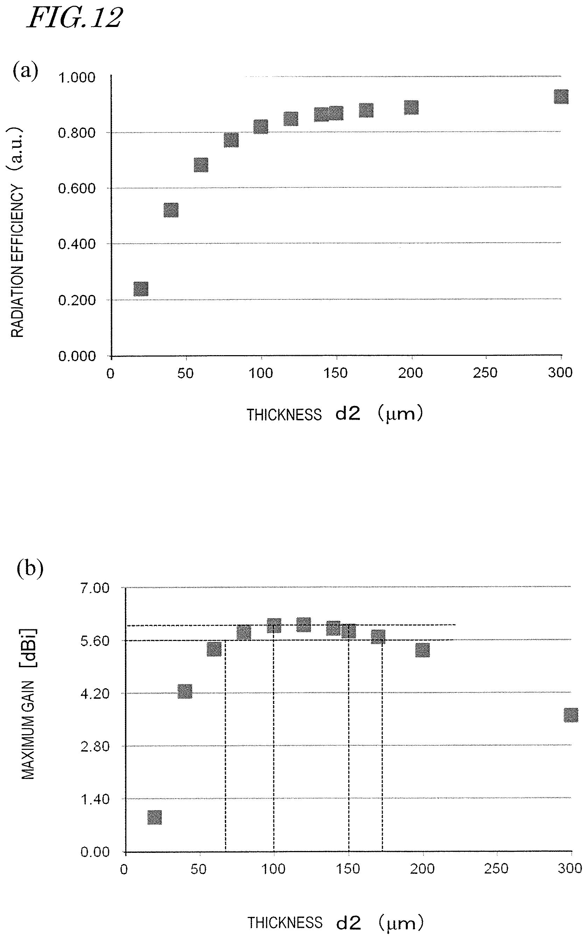

In order to examine the relationship between the thickness **d2** of the ceramic layer between the radiation conductor **31** and the ground conductor **32** and the characteristics of the planar antenna **11,** the radiation efficiency and the maximum gain were calculated while varying the thickness **d2** of the second portion **10d**. FIGS. **12(a)** and **12(b)** show the relationship between the thickness **d2** and the radiation efficiency and the relationship between the thickness **d2** and the maximum gain where the thickness **d1** of the first portion **10c** is 20 µm.

The radiation efficiency improves as the thickness **d2** increases, and becomes generally constant at about 150 µm or more. In contrast, the maximum gain becomes higher in a predetermined range of the thickness **d2.** It can be seen from FIGS. **12(a)** and **12(b)** that the thickness **d2** is preferably 70 µm or more and 180 µm or less and more preferably 100 µm or more and 150 µm or more. Thus, it is possible to realize a high radiation efficiency and a high maximum gain.

From these results, it was found that by covering a radiation conductor of a planar antenna for quasi-millimeter wave/millimeter wave communication with a ceramic material, it is possible to protect the radiation conductor while suppressing the decrease in radiation efficiency.

### INDUSTRIAL APPLICABILITY

The planar antenna, the co-fired ceramic substrate and the quasi-millimeter wave/millimeter wave wireless communication module of the present disclosure are suitably applicable to various high-frequency wireless communication antennas and wireless communication circuits including antennas, and particularly suitably applicable to wireless communication of a quasi-millimeter wave/millimeter wave band.

### REFERENCE SIGNS LIST

10 Multilayer ceramic structure
10a Upper surface
10b Lower surface
10c First portion
10d Second portion
11 Planar antenna
12 Wiring circuit
21, 22, 23Electrode
31 Radiation conductor
31r Region
32 Ground conductor
33 Passive element pattern
34 Conductive via
35 Wiring pattern
41 Solder bump
42 Passive element
43 Active element
51 Circuit substrate
52 Electrode
53 Seal resin
101 Co-fired ceramic substrate
102 Wireless communication module

## Claims

1. A planar antenna comprising:
a multilayer ceramic structure having an upper surface and a lower surface and including a plurality of ceramic layers stacked with each other;
at least one radiation conductor located at one of interfaces between the ceramic layers; and
a ground conductor located on the lower surface of the multilayer ceramic structure or at one of the interfaces between the ceramic layers that is on a lower surface side of the radiation conductor.

2. The planar antenna according to claim 1, wherein of the ceramic layers, the multilayer ceramic structure includes a first portion that is located between the upper surface and the at least one radiation conductor and a second portion that is located between the lower surface and the at least one radiation conductor.

3. The planar antenna according to claim 2, wherein a thickness of the first portion is 70 µm or less.

4. The planar antenna according to claim 2, wherein a thickness of the first portion is 5 µm or more and less than 20 µm.

5. The planar antenna according to any one of claims 2 to 4, wherein the first portion of the multilayer ceramic structure has a composition different from the second portion.

6. The planar antenna according to any one of claims 2 to 4, wherein the first portion of the multilayer ceramic structure has the same composition as the second portion.

7. The planar antenna according to any one of claims 1 to 6, comprising a plurality of radiation conductors.

8. The planar antenna according to any one of claims 1 to 6, wherein an interval between the radiation conductor and the ground conductor is 50 µm or more and 1 mm or less.

9. The planar antenna according to any one of claims 1 to 8, wherein:
the radiation conductor is buried in the first portion and the second portion; and
a height **Hc** of a portion of the radiation conductor that is buried in the first portion **10c** is smaller than a height **Hd** of a portion of the radiation conductor that is buried in the second portion **10d**.

10. A co-fired ceramic substrate comprising:
a multilayer ceramic structure having an upper surface and a lower surface and including a plurality of ceramic layers stacked with each other;
at least one radiation conductor located at one of interfaces between the ceramic layers;
a ground conductor located on the lower surface of the multilayer ceramic structure or at one of the interfaces between the ceramic layers that is on a lower surface side of the radiation conductor;
a plurality of conductor patterns located at one of the interfaces between the ceramic layers that is on a lower surface side of the radiation conductor; and
a plurality of conductive vias provided in one of the ceramic layers that is located on a lower surface side of the radiation conductor, wherein:
a planar antenna is formed by the radiation conductor, the ground conductor, and a portion of the ceramic layers located between the radiation conductor and the ground conductor; and
the conductor patterns and the conductive vias form a passive element and a wire.

11. The co-fired ceramic substrate according to claim 10, wherein of the ceramic layers, the multilayer ceramic structure includes a first portion that is located between the upper surface and the at least one radiation conductor and a second portion that is located between the lower surface and the at least one radiation conductor.

12. The co-fired ceramic substrate according to claim 11, wherein a thickness of the first portion is 70 µm or less.

13. The co-fired ceramic substrate according to claim 11, wherein a thickness of the first portion is 5 µm or more and less than 20 µm.

14. The co-fired ceramic substrate according to any one of claims 10 to 13, wherein an interval between the radiation conductor and the ground conductor is 50 µm or more and 1 mm or less.

15. The co-fired ceramic substrate according to any one of claims 10 to 14, wherein:
the radiation conductor is buried in the first portion and the second portion; and
a height **Hc** of a portion of the radiation conductor that is buried in the first portion **10c** is smaller than a height **Hd** of a portion of the radiation conductor that is buried in the second portion **10d**.

16. The co-fired ceramic substrate according to any one of claims 11 to 15, wherein the first portion of the multilayer ceramic structure has a composition different from the second portion.

17. The co-fired ceramic substrate according to any one of claims 11 to 15, wherein the first portion of the multilayer ceramic structure has the same composition as the second portion.

18. The co-fired ceramic substrate according to any one of claims 10 to 17, comprising a plurality of radiation conductors.

19. The co-fired ceramic substrate according to any one of claims 10 to 18, further comprising at least one of a conductive via and a conductive pattern that is formed in the multilayer ceramic structure and that directly electrically connects together the radiation conductor and the wire.

20. The co-fired ceramic substrate according to any one of claims 10 to 18, further comprising at least one of a conductive via and a conductive pattern that is formed in the multilayer ceramic structure, that is electrically connected to the wire, and that can be electromagnetically coupled to the radiation conductor.

21. The co-fired ceramic substrate according to claim 20, further comprising a plurality of electrodes that are located on the lower surface and that are electrically connected to the wire.

22. A quasi-millimeter wave/millimeter wave wireless communication module comprising:
the co-fired ceramic substrate according to claim 21; and
an active element that is connected to the electrodes located on the lower surface of the multilayer ceramic structure.
